# FASCICULE DE BREVET EUROPEEN

(11) **EP 3 646 393 B1**
(45) Date de publication et mention de la délivrance du brevet: **16.06.2021**
(21) Numéro de dépôt: 18749017.2
(22) Date de dépôt: 27.06.2018
(51) Int. Cl.: H01L 43/00, B82Y 10/00, G06N 10/00, H01L 29/10, H01L 29/76, H01L 29/423

(54) **PROCEDE DE CONTROLE D'UN DISPOSITIF QUANTIQUE A QUBIT DE SPIN**
VERFAHREN ZUR STEUERUNG EINER SPIN-QUBIT-QUANTENVORRICHTUNG
METHOD FOR CONTROLLING A SPIN QUBIT QUANTUM DEVICE

(30) Priorité: 28.06.2017 FR 1755967; 31.01.2018 FR 1850832
(43) Date de publication de la demande: 06.05.2020
(73) Titulaire: Commissariat à l'énergie atomique et aux énergies alternatives, 75015 Paris (FR)
(72) Inventeur: BOURDET, Léo, 38000 Grenoble (FR); HUTIN, Louis, 38950 Saint-Martin-Le-Vinoux (FR); NIQUET, Yann-Michel, 38950 Saint-Martin-Le-Vinoux (FR); VINET, Maud, 38640 Claix (FR)
(74) Mandataire: Brevalex
(86) Numéro de dépôt international: PCT/FR2018/051569
(87) Numéro de publication internationale: WO 2019/002761

(56) Documents cités:
- EP-A1- 2 736 080
- EP-A1- 3 082 073
- WO-A1-2014/146162
- BAUGH J ET AL: "Building a spin quantum bit register using semiconductor nanowires", NANOTECHNOLOGY, IOP, BRISTOL, GB, vol. 21, no. 13, 2 avril 2010 (2010-04-02) , page 134018, XP020174730, ISSN: 0957-4484
- JOHN J. L. MORTON ET AL: "Embracing the quantum limit in silicon computing", NATURE, vol. 479, no. 7373, 1 novembre 2011 (2011-11-01), pages 345-353, XP055474462, GB ISSN: 0028-0836, DOI: 10.1038/nature10681

## Description

### DOMAINE TECHNIQUE ET ART ANTÉRIEUR

L'invention concerne le domaine de la spintronique, et notamment du traitement de l'information quantique, ou de l'informatique quantique. L'invention porte notamment sur un procédé de contrôle d'un dispositif quantique à bits quantiques (appelé quantum bits) ou qubits de spin, permettant de contrôler en champ électrique le spin d'une charge électrique dans du semi-conducteur.

La bande de conduction de certains semi-conducteurs, dont le silicium, présente d'excellentes propriétés, en termes de cohérence, pour réaliser des qubits de spin. La réalisation d'un qubit de spin implique de pouvoir manipuler localement le spin de la charge électrique, c'est-à-dire contrôler le passage entre les états « spin up » et « spin down » représentant les deux états propres du qubit.

Une première possibilité pour réaliser cette manipulation consiste à utiliser un champ magnétique contrôlé de manière locale et auquel le qubit est exposé. Cette première approche se base sur la propriété de certains électrons à absorber puis réémettre l'énergie d'un rayonnement électromagnétique lorsqu'ils sont placés dans un champ magnétique, appelée résonance paramagnétique électronique (RPE) ou résonance de spin électronique (RSE) (en anglais « Electron Spin Resonance », ou ESR). Un tel contrôle local de champ magnétique est toutefois difficile à mettre en œuvre.

Une deuxième possibilité pour manipuler localement le spin d'une charge électrique consiste à utiliser un champ électrique contrôlé de manière locale et auquel le qubit est exposé. Cette approche, appelée EDSR pour « Electric Dipole Spin Resonance », fait appel à un dipôle électronique qui, pour être couplé au spin, nécessite soit la présence d'un champ magnétique inhomogène (inhomogénéité obtenue par exemple par des micro-aimants intégrés), soit exploite le couplage spin-orbite dans le qubit.

L'énergie associée à un état dans lequel se trouve le spin d'un qubit dépend notamment de la vallée de la bande de conduction dans laquelle se trouve la charge électrique dont le spin est manipulé. Par exemple, la bande de conduction du silicium comporte trois groupes de deux vallées. Il est possible de séparer un groupe de deux vallées v1 et v2 des autres en confinant l'électron dans un puits de potentiel induit par exemple par un champ électrique fort, et de choisir que les deux états possibles d'un qubit correspondent aux niveaux d'énergie de la charge électrique à l'état « spin up » et « spin down » dans la vallée de plus basse énergie (v1).

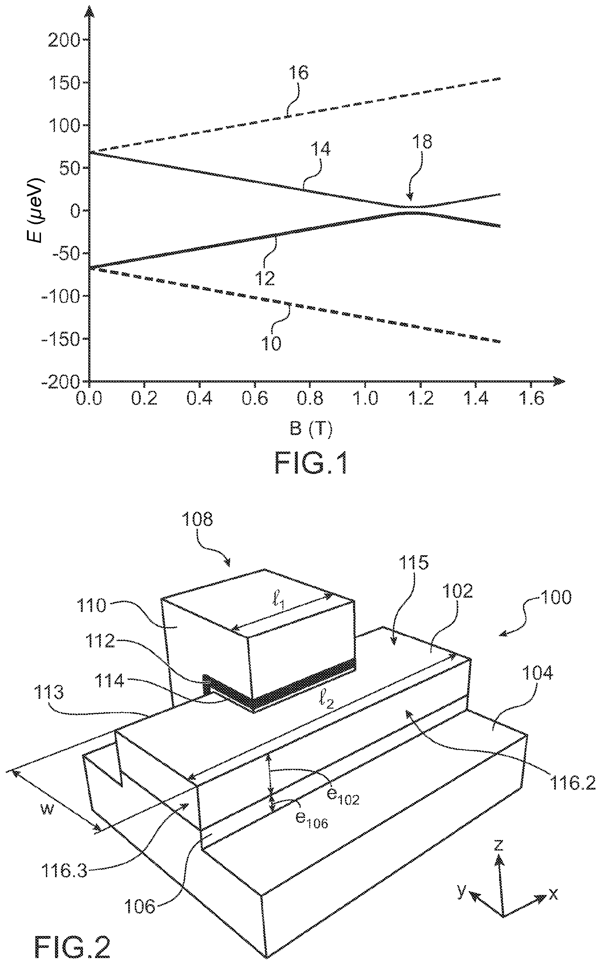

La figure 1 représente le niveau d'énergie (en µeV) d'un électron dans du silicium, dans les deux vallées de plus basses énergies v1 et v2, en fonction de la valeur du champ magnétique B (en T) auquel est soumis le qubit. La référence 10 désigne le niveau d'énergie d'un électron à l'état « spin down » dans la vallée v1, noté v1↓, la référence 12 désigne ce niveau d'énergie dans la vallée v1 à l'état « spin up », noté v1↑, la référence 14 désigne ce niveau d'énergie dans la vallée v2 à l'état « spin down », noté v2↓, et la référence 16 désigne ce niveau d'énergie dans la vallée v2 à l'état « spin up », noté v2↑.

Le couplage spin-orbite inter-vallée, également appelé SOiv, permet de faire tourner conjointement le spin et la vallée et peut-être exploité pour manipuler le spin par EDSR. L'intensité du SOiv dépend de la nature du matériau utilisé et est caractérisée par l'élément de matrice Mₛₒ = < v1↑ | Hₛₒ | v2↓> de l'Hamiltonien de couplage spin-orbite Hso entre les états v1↑ et v2↓. Dans le silicium, Mₛₒ est naturellement faible (de quelques µeV à une dizaine de µeV). Ses effets sont néanmoins exacerbés lorsque l'énergie séparant l'état v1↑ de l'état v2↓est petite. L'EDSR (transition entre v1↓ et v1↑) résulte alors d'un couplage v1↓ - v2↓ par le champ électrique et d'un couplage v2↓ - v1↑ par le SOiv.

La manipulation de l'état du spin par EDSR est extrêmement dépendante de l'écart d'énergie inter-vallée, ou « valley-orbit splitting », noté Δ et qui est représentatif, sur l'exemple de la figure 1, de l'écart entre les niveaux d'énergie v1↑ et v2↑. Sur la figure 1, l'écart entre les niveaux d'énergie v1↑ et v2↓ est égal à Δ - g. µ_{B}.B, avec g correspondant au facteur de Landé, µ_{B} le magnéton de Bohr, et B le champ magnétique auquel le qubit est exposé. La référence 18 notée sur la figure 1 désigne une région de résonance dans laquelle les niveaux d'énergie des états v1↑ et v2↓ sont proches l'un de l'autre. Au-delà de cette région de résonance 18 (qui correspond à la partie où le champ magnétique B est supérieur à environ 1,2 T sur la figure 1), la référence 12 désigne le niveau d'énergie de l'état v2↓ et la référence 14 désigne le niveau d'énergie de l'état v1↑.

Il est donc intéressant d'avoir une structure de qubit permettant d'augmenter les effets du SOiv.

Le document « Electrically driven spin qubit based on valley mixing » de W. Huang et al., Physical Review B 95, 075403 (2017), décrit une structure de qubit dans laquelle, afin d'avoir un SOiv important, une couche de silicium est modifiée afin de former une marche de quelques (1 à 5) couches atomiques. Les effets du SOiv sont exacerbés lorsque la fonction d'onde de l'électron est positionnée au niveau de cette marche. Cette structure exploite le SOiv entre les états v1↑, v1↓ et des états excités de la vallée v2 non reproduits sur la figure 1.

Un premier problème rencontré avec une telle structure est que la position, hauteur et morphologie d'une marche est très difficile à maîtriser (une variation de hauteur d'une couche atomique, soit environ 0.2 nm, modifiant sensiblement les propriétés du qubit). En outre, bien que la fréquence de Rabi (vitesse de rotation des spins) augmente avec la hauteur de la marche, il devient de plus en plus difficile de faire franchir cette marche à l'électron. Cela entraîne une perte de contrôle électrique (instabilité) pour des marches supérieures à 4-5 couches atomiques (0.8 à 1 nm).

La fréquence de Rabi obtenue pour une telle structure comprenant une marche dont l'épaisseur est de l'ordre de 1 à 4 couches atomiques, soit environ 0,2 à 0,8 nm, est de l'ordre de 2 à 3 MHz. Une fréquence de Rabi plus importante peut être obtenue en augmentant la hauteur de la marche, par exemple environ 10 MHz ou plus pour une marche d'épaisseur égale à 1 nm ou plus, mais au détriment de la stabilité de l'état du spin.

Des autres procédés de l'art antérieur sont décrits par EP 3 082 073 A1 ; WO 2014 / 146162 A1; EP 2 736 080 A1; J. Baugh et al., "Building a spin quantum bit register using semiconductor nanowires", Nanotechnology, vol. 21, 134018, p. 1-6, (2010); John J.L. Morton et al., "Embracing the quantum limit in silicon computing", Nature, vol. 479, p. 345-353, (2011).

### EXPOSÉ DE L'INVENTION

Un but de la présente invention est de proposer un procédé de contrôle d'un dispositif quantique à un ou plusieurs qubits de spin, dans lequel les effets du SOiv sont contrôlés individuellement pour le ou chaque qubit du dispositif sans avoir à modifier la valeur du champ magnétique auquel le ou les qubits sont exposés et dont la valeur peut être importante, et permettant de résoudre les problèmes de stabilité d'état de spin rencontrés avec les structures de l'art antérieur. Un autre but de la présente invention est de proposer un dimensionnement du dispositif vis-à-vis des propriétés des matériaux, des symétries de la structure et des signaux de contrôle électrique permettant de manipuler efficacement le spin tout en garantissant sa stabilité en dehors des opérations de manipulation.

Pour cela, la présente invention propose un procédé de contrôle d'un dispositif quantique à qubit de spin, dans lequel le dispositif quantique comporte au moins :
- une portion de semi-conducteur comprenant une face supérieure, une face inférieure et des faces latérales sensiblement perpendiculaires aux faces supérieure et inférieure ;
- une couche diélectrique sur laquelle est disposée la portion de semi-conducteur telle que la face inférieure de la portion de semi-conducteur soit disposée du côté de la couche diélectrique ;
- une grille avant recouvrant partiellement au moins une arrête supérieure de la portion de semi-conducteur formée à une jonction entre la face supérieure et une première des faces latérales ;
- une grille arrière telle que la couche diélectrique soit disposée entre la grille arrière et la portion de semi-conducteur ;
le procédé comprenant, lors d'une manipulation, ou changement, d'un état du spin du qubit du dispositif quantique :
- l'exposition du dispositif quantique à un champ magnétique B, et
- l'application, sur la grille arrière, d'un potentiel électrique Vbg de valeur telle que Δ(Vbg) < g.µ_{B}.B + 2|M_{SO}|, et l'application, sur la grille avant, d'un potentiel électrique Vfg confinant au moins une charge électrique sous l'arrête supérieure et d'un signal électrique RF déclenchant un changement d'état du spin du qubit du dispositif quantique,
avec g correspondant au facteur de Landé, µ_{B} correspondant au magnéton de Bohr, Δ correspondant à l'écart d'énergie inter-vallée dans la portion de semi-conducteur, et Mₛₒ le couplage spin-orbite inter-vallées, ou couplage SOiv, du dispositif quantique.

Ce procédé fait appel à un dispositif quantique comprenant une grille avant et une grille arrière. L'utilisation de deux grilles permet de contrôler séparément le confinement par le champ électrique et l'écart d'énergie inter-vallée Δ. Plus précisément, le potentiel électrique Vfg appliqué sur la grille avant peut contrôler essentiellement le confinement de la charge électrique dont on manipule le spin dans le dispositif. Le potentiel électrique Vbg appliqué sur la grille arrière permet d'ajuster Δ sans risque que l'électron ne quitte le dispositif, au besoin en agissant conjointement sur la grille avant pour corriger le confinement. En effet, si la seule grille avant est utilisée pour contrôler Δ, ce dernier ne peut être ajusté sans courir le risque de déconfiner et de perdre la charge électrique. L'utilisation de la grille arrière permet de découpler confinement et ajustement de Δ.

Il est possible d'agir à la fois sur Vfg et Vbg pour atteindre la résonance voire de dépasser la résonance, sans déconfiner la charge électrique dont le spin est manipulé. L'action de la grille arrière engendrée par l'application de Vbg peut donc (mais pas nécessairement) s'accompagner d'une correction engendrée par l'application de Vfg sur la grille avant.

Dans ce dispositif quantique, un couplage SOiv Mₛₒ important et bien contrôlé est obtenu du fait que grâce aux signaux appliqués sur la grille avant et la grille arrière lors d'une manipulation de l'état du spin, la fonction d'onde de la charge électrique dont le spin est manipulé est localisée à proximité de l'arrête supérieure de la portion de semi-conducteur qui est recouverte par la grille avant. L'intersection de deux faces perpendiculaires formant l'arrête supérieure recouverte par la grille avant exacerbe la contribution des interfaces au SOiv, et lève les limites imposées par les symétries au SOiv (moins la structure est symétrique, plus les effets du SOiv sont potentiellement importants).

La manipulation de l'état de la charge électrique correspond à un changement d'état du spin de la charge électrique (passage de l'état « spin up » à l'état « spin down » ou inversement) et à un changement de la vallée de la bande de conduction dans laquelle se trouve la charge électrique dont le spin est manipulé. En reprenant la figure 1 précédemment décrite, si les valeurs de la tension Vbg et du champ magnétique B sont telles que la manipulation a lieu à gauche de la région de résonance 18, cette manipulation concerne essentiellement le spin du qubit, l'information quantique correspondant à l'état « spin up » ou « spin down » du spin de la charge dans une même vallée, par exemple les états v1↑ et v1↓, qui correspondent aux deux états de l'information quantique. Un tel qubit se trouvant dans un régime dit de qubit de spin est difficile à manipuler par EDSR mais il est robuste vis-à-vis de la décohérence (perte de l'information quantique). Si les valeurs de la tension Vbg et du champ magnétique B sont telles que la manipulation a lieu à droite de la région de résonance 18, cette manipulation concerne essentiellement la vallée de la bande de conduction de la charge électrique : on peut dans ce cas parler de qubit se trouvant dans un régime dit de qubit de vallée, dans lequel l'information quantique est encodée suivant la vallée dans laquelle se trouve la charge, par exemple les états v1↓ et v2↓, qui correspondent dans ce cas aux deux états de l'information quantique. Un tel qubit se trouvant dans un régime de qubit de vallée est plus facile à manipuler par EDSR qu'un qubit se trouvant dans un régime de qubit de spin, mais la durée de cohérence d'un tel qubit en régime de qubit de vallée est sensiblement plus courte que celle d'un qubit se trouvant en régime de qubit de spin.

Ce dispositif quantique propose une structure de qubit permettant d'augmenter les effets du SOiv afin de pouvoir basculer facilement du régime de qubit de spin au régime de qubit de vallée pour manipuler le spin. Plus le SOiv est grand, plus un changement adiabatique de régime du qubit peut d'effectuer rapidement.

Au cours du procédé, le dispositif quantique peut être exposé à un champ magnétique B de valeur telle que g.µ_{B}.B > min(Δ(Vbg))-2| Mₛₒ |, ce qui permet de garantir que la condition de manipulation électrique Δ(Vbg) < g.µ_{B}.B + 2| Mₛₒ | peut être atteinte. La manipulation de l'état du spin du qubit se produit donc en appliquant sur la grille arrière un potentiel électrique Vbg de valeur telle que Δ(Vbg) < g.µ_{B}.B + 2|Mₛₒ| (condition de manipulation électrique), et sur la grille avant, un signal électrique RF déclenchant le changement d'état du spin. Ces conditions peuvent être remplies individuellement pour le ou chaque qubit de spin, quelle que soit la valeur du champ magnétique B auquel le dispositif quantique est soumis.

La manipulation de l'état du spin du qubit peut être réalisée au niveau de la région de résonance en appliquant, sur la grille arrière, un potentiel électrique Vbg de valeur telle que |Δ(Vbg) - g.µ_{B}.B| ≤ 2|M_{SO}| (c'est-à-dire g.µ_{B}.B - 2|M_{SO}| ≤ Δ(Vbg) ≤ g.µ_{B}.B + 2|M_{SO}|).

La largeur à mi-hauteur de la résonance en champ magnétique qui sépare les régimes qubit de spin /qubit de vallée est d'environ 4|M_{SO}|. On peut donc atteindre au moins 33 % de la fréquence de Rabi maximale (laquelle est définie en s'enfonçant profondément dans le régime qubit de vallée avec Δ(Vbg) < g.µ_{B}.B -10|M_{SO}|) dès lors que Δ(Vbg) < g. µ_{B}.B + 2|M_{SO}|.

Il est également possible d'avoir le champ magnétique B tel que g.µ_{B}.B > min(Δ(Vbg)).

De plus, à l'issue de cette phase de manipulation, par exemple pendant les phases d'initialisation et de lecture du ou des qubits, la valeur de Vbg peut être modifiée afin de ne plus satisfaire la condition Δ(Vbg) < g.µ_{B}.B + 2|M_{SO}| qui n'est pas favorable pour la stabilité de l'état de spin, et cela sans avoir à modifier la valeur du champ magnétique B auquel est soumis le dispositif quantique. Le procédé permet donc de découpler la manipulation de spin de son initialisation et sa lecture.

De plus, la structure du dispositif quantique ne comporte pas les limitations imposées dans celle de l'art antérieur (lorsqu'une marche est utilisée pour localiser la fonction d'onde), à savoir une fréquence de Rabi limitée.

Dans l'ensemble de la présente demande, le terme « recouvre » est utilisé entre deux éléments pour désigner le fait que ces deux éléments sont disposés l'un contre l'autre, soit directement (c'est-à-dire sans élément supplémentaire entre eux) soit indirectement (avec un ou plusieurs éléments supplémentaires interposés entre eux).

En considérant par exemple que la portion de semi-conducteur est formée d'une partie supérieure et d'une partie inférieure séparées l'une de l'autre par un premier plan parallèle aux faces supérieure et inférieure et passant par le centre de la portion de semi-conducteur, et de deux parties latérales séparées l'une de l'autre par un deuxième plan passant également par le centre de la portion de semi-conducteur et parallèle à la face latérale formant l'arrête recouverte par la grille avant, la fonction d'onde de la charge électrique dont le spin est manipulé peut être localisée, lors de la manipulation de l'état du spin, dans la partie supérieure et dans la partie latérale qui inclut l'arrête supérieure recouverte par la grille avant, c'est-à-dire à proximité de cette arrête supérieure, sous la partie de la portion de semi-conducteur recouverte par la grille avant.

Le procédé peut comporter en outre, lors d'une phase d'initialisation ou de lecture du qubit, l'application du potentiel électrique Vbg de valeur telle que Δ(Vbg) > g.µ_{B}.B + 10|M_{SO}|. Dans ce cas, l'énergie de la charge électrique est telle qu'elle est éloignée de la région de résonance, améliorant ainsi la stabilité de l'état du spin de cette charge lors de l'initialisation ou de la lecture du qubit.

Il est également possible que, lors d'une phase d'initialisation ou de lecture du qubit, l'application du potentiel électrique Vbg de valeur telle que |Δ(Vbg) - g.µ_{B}.B|≥10|M_{SO}|.

La portion de semi-conducteur et/ou la grille avant peut être dissymétrique par rapport à un plan passant par le centre de la portion de semi-conducteur et parallèle à au moins une deuxième des faces latérales de la portion de semi-conducteur. Dans cette configuration, la grille avant et la portion de semi-conducteur forment un ensemble dissymétrique contribuant à l'obtention d'un SOiv important. Lors d'une manipulation de l'état du spin, la charge électrique dont le spin est manipulé est localisée à proximité de l'arrête de la portion de semi-conducteur recouverte par la grille avant, via l'application de potentiels électriques sur les grilles avant et arrière.

Les première et deuxième faces latérales de la portion de semi-conducteur peuvent correspondre à la même face latérale de la portion de semi-conducteur. Dans ce cas, la dissymétrie est notamment due à la grille avant qui recouvre cette face latérale et la partie de la face supérieure formant, avec cette face latérale, l'arrête supérieure recouverte par la grille avant.

La grille avant peut recouvrir une seule arrête supérieure de la portion de semi-conducteur. Dans ce cas, un SOiv important est obtenu lors d'une manipulation de l'état du spin grâce à la localisation de la charge électrique dont le spin est manipulé à proximité de cette arrête supérieure, et non dans une partie supérieure centrale de la portion de semi-conducteur.

La grille avant peut comporter deux parties distinctes recouvrant chacune une seule arrête supérieure de la portion de semi-conducteur formée à une jonction de la face supérieure et de l'une des faces latérales de la portion de semi-conducteur, les deux arrêtes supérieures recouvertes par les deux parties distinctes de la grille avant étant sensiblement parallèles l'une de l'autre. Les deux parties de la grille avant sont qualifiées de distinctes car elles ne sont pas en contact électrique l'une avec l'autre. Avec une telle structure, il est par exemple possible de localiser un électron sous chaque grille (à proximité de l'arrête recouverte par la dite grille), afin de réaliser deux qubits couplés, soit pour implémenter une porte à deux qubits, soit pour lire un des deux qubits (dont l'état est inconnu) en le couplant avec l'autre (préparé dans un état connu).

Le dispositif quantique peut comporter en outre au moins deux grilles latérales recouvrant des deuxièmes parties de la portion de semi-conducteur situées de part et d'autre d'une première partie de la portion de semi-conducteur définissant le qubit, et, lors de la manipulation de l'état du spin du qubit du dispositif quantique, des potentiels électriques de valeurs différentes l'une de l'autre peuvent être appliqués sur les grilles latérales. De telles grilles latérales forment des barrières pouvant servir à isoler le qubit lorsque le dispositif quantique est une structure à multiple puits quantiques. De plus, en appliquant des potentiels électriques de valeurs différentes sur ces grilles latérales, une dissymétrie est générée au sein de la portion de semi-conducteur, augmentant ainsi le SOiv obtenu.

Dans un mode de réalisation offrant plus de compacité, le dispositif quantique peut comporter en outre au moins deux espaceurs électriquement conducteurs distincts (non reliés électriquement entre eux) et disposés contre deux côtés opposés de la grille avant et, lors de la manipulation de l'état du spin du qubit du dispositif quantique, des potentiels électriques de valeurs différentes l'une de l'autre peuvent être appliqués sur les deux espaceurs électriquement conducteurs. De tels espaceurs forment dans ce cas des barrières favorisant l'isolement du qubit dans la portion de semi-conducteur.

La portion de semi-conducteur peut comporter quatre extrémités reliées à une partie centrale et chacune recouverte au moins partiellement par une partie de la grille avant distincte des autres parties de la grille avant, et, lors d'une manipulation d'un état du spin du qubit du dispositif quantique, le signal RF peut être appliqué sur deux parties voisines de la grille avant. Dans une telle configuration, lors d'une manipulation de l'état du spin, la fonction d'onde de la charge électrique peut alors être localisée à proximité d'une arrête supérieure de la portion de semi-conducteur, dans une partie se trouvant entre les deux extrémités recouvertes par les parties de la grille avant sur lesquelles le signal RF est appliqué.

Le dispositif quantique peut comporter plusieurs qubits de spin formés dans plusieurs portions de semi-conducteur distinctes, la grille arrière pouvant être couplée à l'ensemble des portions de semi-conducteur distinctes. Dans ce cas, la grille arrière est globale à l'ensemble des qubits, et, lors d'une manipulation de l'état du spin des qubits, la valeur de Δ est contrôlée notamment par l'intermédiaire de la grille avant de chacun des qubits.

En variante, le dispositif quantique peut comporter plusieurs qubits de spin formés dans plusieurs portions de semi-conducteur distinctes, et peut comporter plusieurs grilles arrières chacune couplée à l'une des portions de semi-conducteur. Dans ce cas, les grilles arrières sont locales et chacune peut servir à réaliser un ajustement individuel de la valeur de Δ du qubit auquel elle appartient.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente les niveaux d'énergie d'un électron dans des vallées différentes, dans du silicium ;
- les figures 2 à 4 correspondent à différentes vues schématiques d'un dispositif quantique à qubit de spin contrôlé par le procédé selon invention, selon un premier mode de réalisation ;
- la figure 5 représente la valeur l'écart d'énergie inter-vallée obtenu en faisant varier la valeur du potentiel électrique appliqué sur la grille arrière du dispositif quantique à qubit de spin selon le premier mode de réalisation ;
- la figure 6 représente la valeur de la fréquence de Rabi obtenue en faisant varier la valeur du potentiel électrique appliqué sur la grille arrière du dispositif quantique à qubit de spin, objet de la présente invention, selon le premier mode de réalisation ;
- la figure 7 est une vue en coupe du dispositif quantique à qubit de spin contrôlé par le procédé selon l'invention, selon un deuxième mode de réalisation ;
- la figure 8 correspond à une vue en perspective, schématique et partielle, d'un dispositif quantique à qubit de spin contrôlé par le procédé selon l'invention, selon un troisième mode de réalisation ;
- la figure 9 représente l'augmentation du SOiv obtenue en augmentant une différence de potentiels appliqués aux extrémités du nanofil du dispositif quantique à qubit de spin selon le troisième mode de réalisation ;
- la figure 10 représente des exemples de potentiels appliqués sur les grilles avant et arrière lors d'un procédé de contrôle d'un dispositif quantique à qubit de spin, objet de la présente invention ;
- la figure 11 représente une vue en perspective, schématique et partielle, d'un dispositif quantique à qubit de spin, objet de la présente invention, selon un quatrième mode de réalisation ;
- la figure 12 représente une vue en perspective, schématique et partielle, d'un dispositif quantique à qubit de spin, objet de la présente invention, selon un cinquième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord aux figures 2 à 4 qui correspondent à différentes vues d'un dispositif quantique 100 selon un premier mode de réalisation. Sur ces figures, seule une partie du dispositif 100 formant un seul qubit de spin est représentée, bien que le dispositif 100 comporte avantageusement plusieurs qubits de spin formés les uns à côté des autres sur un même substrat, par exemple disposés en formant une matrice de qubits de spin.

Le dispositif 100 comporte une portion 102 de semi-conducteur, ici correspondant à un nanofil de silicium. La longueur l2 de la portion 102, qui correspond à sa dimension selon l'axe X sur les figures 2 à 4, est typiquement comprise entre environ 15 et 100 nm, sa largeur w, qui correspond à sa dimension selon l'axe Y, est par exemple comprise avantageusement entre environ 15 et 100 nm (mais peut être arbitrairement grande), et son épaisseur e₁₀₂, qui correspond à sa dimension selon l'axe Z, peut être comprise entre environ 4 et 40 nm.

En outre, dans ce premier mode de réalisation, la portion 102 a une forme sensiblement parallélépipédique rectangle et comporte une face supérieure 115, une face inférieure 117 et quatre faces latérales 116 (référencées 116.1 à 116.4 sur les figures 2 à 4) qui sont sensiblement perpendiculaires aux faces supérieure et inférieure 115, 117. D'autres formes de portion 102 de semi-conducteur sont toutefois envisageables.

Dans le dispositif 100, la portion 102 est destinée à former une boîte quantique correspondant à un qubit de spin.

La portion 102 est disposée sur une couche diélectrique 104 comprenant par exemple du SiO₂. La face inférieure 117 de la portion 102 repose sur une partie supérieure 106 de la couche 104 qui a une épaisseur e₁₀₆ par exemple comprise entre environ 0 nm (cette partie supérieure 106 peut ne pas être présente) et 10 nm, et qui est gravée selon le motif formé par la portion 102 dans le plan (X,Y) qui est parallèles aux faces supérieure et inférieure 115, 117.

La portion 102 est recouverte partiellement par une grille avant 108. Cette grille avant 108 est formée par une première portion électriquement conductrice 110 et une première portion diélectrique 112 disposée entre la première portion électriquement conductrice 110 et la portion 102. De manière optionnelle, une deuxième portion diélectrique 114 peut être disposée entre la première portion diélectrique 112 et la portion 102, comme c'est le cas sur les figures 2 à 4.

Dans ce premier mode de réalisation, la grille avant 108 recouvre une partie d'une seule des faces latérales 116 de la portion 102. Sur les figures 2 à 4, les faces latérales 116 de la portion 102, référencées 116.1 à 116.4, correspondent aux quatre faces sensiblement parallèles aux plans (X,Z) et (Y,Z). Sur ces figures, la grille avant 108 recouvre une partie de la face latérale référencée 116.1 mais ne recouvre pas les faces latérales référencées 116.2, 116.3 et 116.4. De plus, la grille avant 108 recouvre une partie de la face supérieure 115 de la portion 102.

Sur les figures 2 à 4, la dimension « a » représente la partie de la largeur de la portion 102 recouverte par la grille avant 108, la valeur du rapport a/w étant comprise dans l'intervalle ]0 ; 1[.

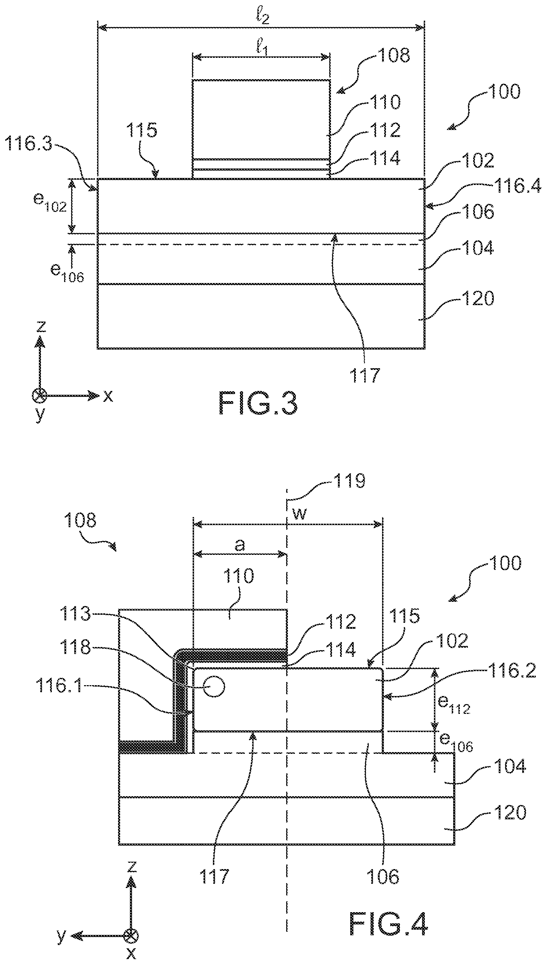

Le dispositif 100 comporte également une grille arrière 120, visible sur les figures 3 et 4, permettant de contrôler de manière électrostatique la position de la fonction d'onde du qubit et donc de modifier les valeurs de Δ et Mₛₒ lors d'une manipulation de l'état du spin du qubit. Cette grille arrière 120 permet d'ajuster le champ électrique vertical produit dans la portion 102.

La longueur l1 de la grille avant 108 est inférieure à la longueur l2 de la portion 102 afin de former une boîte quantique dans la partie du nanofil 102 recouverte par la grille 108.

En recouvrant ainsi une seule face latérale 116.1 et une partie de la face supérieure 115 de la portion 102, la grille avant 108 recouvre partiellement (du fait que l1 < l2) une seule arrête supérieure 113 de la portion 102 formée à la jonction de la face supérieure 115 et de la face latérale 116.1 de la portion 102. Cette configuration particulière de la grille avant 108 introduit une dissymétrie dans la structure du dispositif 100, en considérant les deux parties du dispositif 100 se trouvant de chaque côté d'un plan parallèle au plan (X,Z) et passant par le milieu de la portion 102, ces deux parties étant différentes l'une de l'autre. Sur la figure 4, ce plan parallèle au plan (X,Z) et passant par le milieu du nanofil 102 est représenté symboliquement par un trait pointillé désigné par la référence 119.

Bien que non représentés, le dispositif 100 peut comporter des moyens aptes à générer le champ magnétique B homogène auquel la portion 102 est exposée lors de l'utilisation du dispositif 100. La valeur du champ magnétique B peut être comprise entre environ 200 mT et 2T.

Grâce à la structure dissymétrique de la grille avant 108, le potentiel électrique appliqué sur la grille arrière 120 et celui appliqué sur la grille avant 108 lors de la manipulation d'un état du spin du qubit permettent de confiner une charge électrique dans une région de la portion 102 proche de l'arrête supérieure 113 de la portion 102 et recouverte par la grille avant 108 et donc de localiser la fonction d'onde de cette charge à proximité de cette arrête supérieure 113. La région de la portion 102 dans laquelle la fonction d'onde de la charge électrique dont le spin est manipulé est localisée est représentée symboliquement en trait pointillé sur la figure 4 et est désignée par la référence 118.

En considérant que la portion 102 de semi-conducteur est formée d'une partie supérieure et d'une partie inférieure séparées l'une de l'autre par un premier plan parallèle aux faces supérieure et inférieure 115, 117 et passant par le centre de la portion 102, et de deux parties latérales séparées l'une de l'autre par un deuxième plan passant également par le centre de la portion 102 et parallèle à la face latérale 116.1 formant l'arrête 113 recouverte par la grille avant 108, la fonction d'onde de la charge électrique dont le spin est manipulé est localisée, lors de la manipulation de l'état du spin, dans la partie supérieure et dans la partie latérale qui inclut l'arrête supérieure 113, c'est-à-dire à proximité de cette arrête supérieure 113, sous la partie de la portion 102 recouverte par la grille avant 108.

Le confinement à l'intersection des faces 115 et 116.1 exacerbe le SOiv en exaltant la contribution des surfaces et en levant les limitations imposées par les symétries (confinement dans une structure aussi peu symétrique que possible). En ajustant à la fois les potentiels de grille avant (Vfg) et arrière (Vbg), il est possible en outre de contrôler le champ électrique dans la structure et de bien maîtriser la position de la charge au sein de la portion 102, en particulier de bien maîtriser la distance de cette charge par rapport aux interfaces entre la portion 102 et les couches diélectriques 104 et 106. Or, la valeur de l'écart d'énergie inter-vallées Δ est particulièrement dépendante de la proximité de la charge électrique avec ces interfaces. La valeur du potentiel électrique Vbg appliqué sur la grille arrière 120 peut donc être ajustée pour que l'énergie de cette charge soit proche ou au-delà du point de la région de résonance (région 18 de la figure 1) où les niveaux v1↑ et v2↓ se croisent, c'est-à-dire vérifie la condition Δ(Vbg) < g.µ_{B}.B + 2|Mₛₒ| (ou |Δ(Vbg) - g.µ_{B}.B| ≤ 2|M_{SO}| pour rester proche de la région de résonance).

On peut ainsi obtenir rapidement le passage de l'état v1↓ à l'état v2↓ via l'application d'un signal RF sur la grille avant 108, puis de l'état v2↓ à l'état v1↑ grâce au couplage spin-orbite en ajustant Vbg de façon à revenir de manière adiabatique dans le régime de qubit de spin avec Δ(Vbg) > g.µ_{B}.B + 2|M_{SO}|. On réalise ainsi une rotation nette de l'état vl↓ vers l'état v1↑, caractéristique de l'EDSR .

En contrôlant ainsi la valeur de Δ, il est par exemple possible, lors d'une phase de manipulation de l'état du spin (passage de l'un à l'autre des états v1↑ et v1↓), d'appliquer sur la grille arrière 120 et sur la grille avant 108 des potentiels permettant au qubit de satisfaire à la condition Δ(Vbg) < g.µ_{B}.B + 2|Mₛₒ|, et de réaliser rapidement une manipulation de l'état du qubit.

A l'issue de cette manipulation, par exemple pendant une phase d'initialisation, de lecture ou de repos du qubit, la valeur du potentiel appliqué sur la grille arrière 120 peut être modifiée afin d'augmenter la valeur de Δ, ce qui provoque un retour dans le régime de qubit de spin loin de la région de résonance dans laquelle le niveau d'énergie de l'état v1↑ est proche de celui de l'état v2↓, améliorant ainsi la stabilité de l'état du spin. Lors d'une phase d'initialisation ou de lecture du qubit, la valeur du potentiel électrique Vbg appliqué peut être telle que Δ(Vbg) > g.µ_{B}.B + 10|M_{SO}| (ou bien encore telle que |Δ(Vbg) - g· µ_{B}.B|≥ 10|M_{SO}|).

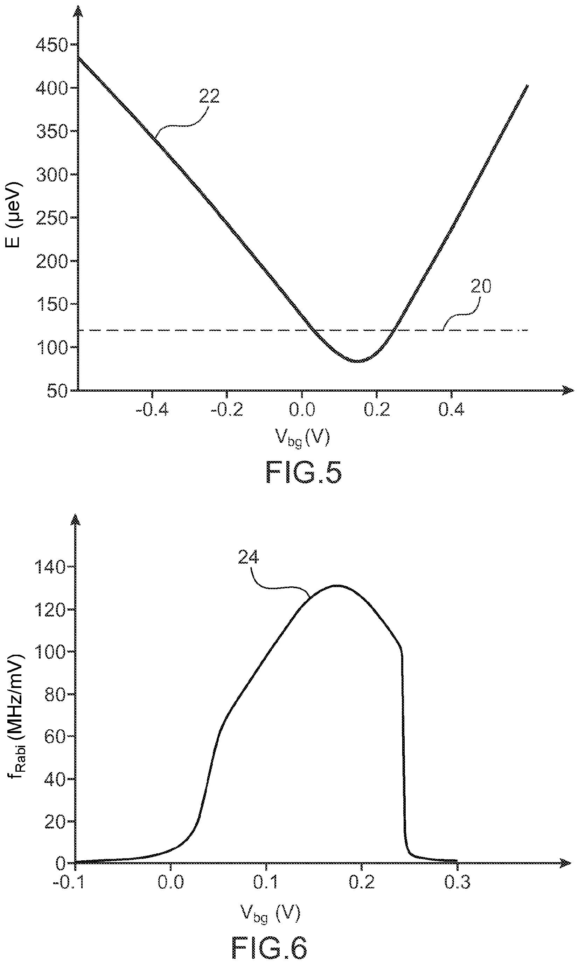

La figure 5 représente la valeur de Δ obtenue dans le dispositif 100 en fonction de la valeur du potentiel électrique Vbg appliqué sur la grille arrière 120.

La valeur du champ magnétique B est avantageusement choisie telle que la valeur de g.µ_{B}.B soit supérieure à min(Δ(Vbg))-2|Mₛₒ|, avec min(Δ(Vbg)) qui correspond à la valeur minimale de Δ(Vbg) du dispositif 100. Lorsque le dispositif 100 comporte plusieurs qubits, cette valeur du champ magnétique B est choisie en considérant la relation ci-dessus pour chacun des qubits du dispositif 100. Sur l'exemple de la figure 5, la valeur du champ magnétique B est fixée telle que la valeur de g.µ_{B}.B, désignée par le trait pointillé référencé 20, soit supérieure à la valeur minimale de Δ(Vbg) représenté par la courbe 22, et par exemple égale à environ 1T. Lors d'une manipulation de l'état du spin, le potentiel Vbg est choisi telle que Δ(Vbg) < g.µ_{B}.B + 2|M_{SO}|. Cela correspond, sur la figure 5, à un Vbg compris entre les deux intersections de la courbe 22 avec la droite 20 qui correspondent aux croisements entre les états v1↑ et v2↓.

En appliquant en outre le signal RF avec une bonne fréquence de résonance sur la grille avant 108, une modulation de la fréquence de Rabi en fonction de Vbg est obtenue. La courbe 24 représentée sur la figure 6 correspond à la fréquence de Rabi (fréquence de rotation du spin) obtenue le long de la ligne 20 représentée sur la figure 5.

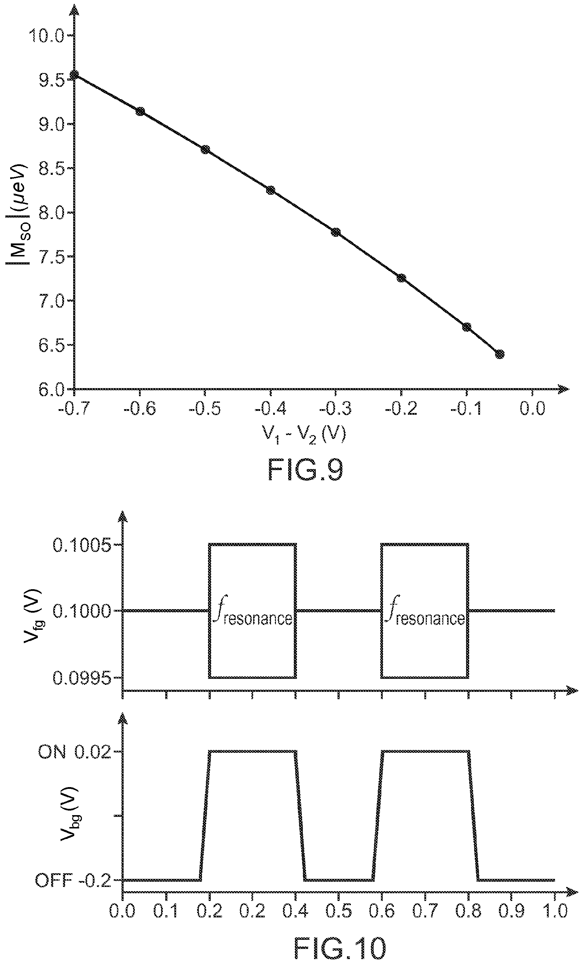

Des exemples de signaux Vbg (potentiel électrique appliqué sur la grille arrière 120) et Vfg (potentiel appliqué sur la grille avant 108) appliqués lors des différentes phases décrites précédemment sont représentés sur la figure 10. Dans ces exemples, lors des phases d'initialisation ou de lecture du qubit, le potentiel Vfg vaut 0,1 V et le potentiel Vbg est égal à -0,2 V.

Lors d'une étape de manipulation de l'état du spin, un signal RF oscillant entre -0,5 mV et 0,5 mV est ajouté au potentiel Vfg, et le potentiel Vbg est égal à 0,02 V. La fréquence *f* du signal RF est égale à ΔE/h, avec ΔE correspondant à l'écart entre les courbes 10 et 12 représentées sur la figure 1, c'est-à-dire l'écart entre les niveaux d'énergie v1↓ et v1↑, avant la résonance 18, ou entre les niveaux v1↓ et v2↓ après cette résonance (h est la constante de Planck). La valeur du champ magnétique B est par exemple choisie telle que ΔE >> kT, c'est-à-dire *f* > 4 GHz à T = 0,1 K, et telle que *f* < 50 GHz afin de travailler à des fréquences accessibles avec une électronique rapide

De manière générale, le potentiel Vfg appliqué peut être positif et avoir une amplitude de l'ordre de 0,1 V, par exemple compris entre 0,05 V et 0,2 V. La valeur de ce potentiel dépend notamment de la géométrie du dispositif quantique 100, de ses dimensions, des matériaux utilisés, etc.

En dehors de cette phase de manipulation de l'état du spin, par exemple lors d'une phase d'initialisation ou de lecture du qubit, le potentiel électrique Vbg appliqué sur la grille arrière est tel que le qubit se trouve hors résonance afin d'éviter tout passage intempestif entre les états v1↑ et v1↓assisté par le SOiv via l'état v2↓. Pour cela, le potentiel électrique Vbg peut être tel que Δ(Vbg) > g.µ_{B}.B + 10|M_{SO}|.

De plus, en considérant plusieurs qubits de spin formés au sein du dispositif 100, Δ peut être commandé individuellement pour chaque qubit de spin formé dans une portion de semi-conducteur similaire à la portion 102 associé à une grille avant 108 qui peut être commandée indépendamment des autres grilles, sans avoir à modifier la valeur du champ magnétique B auquel tous les qubits sont soumis. Cela est très intéressant du fait que dans un même champ magnétique B, l'énergie au sein des différents qubits varie, notamment en raison des différentes rugosités d'interface dans ces qubits.

Dans ce premier mode de réalisation, la grille arrière 120 est formée par une couche électriquement conductrice, comprenant par exemple du semi-conducteur dopé et/ou un métal, disposée sous la couche diélectrique 104 telle que la couche diélectrique 104 soit disposée entre la grille arrière 120 et la portion 102.

Cette grille arrière 120 peut être associée à un ou plusieurs qubits. Ainsi, la grille arrière 120 peut être soit réalisée de manière globale pour tous les qubits, par exemple sous la forme d'un plan conducteur disposé sous l'ensemble des qubits, soit de manière locale et être ainsi associée à un qubit ou une partie seulement des qubits.

Dans le premier mode de réalisation précédemment décrit, la valeur du SOiv est augmenté grâce à la dissymétrie de la grille avant 108 par rapport au plan parallèle au plan (X,Z) et passant par le milieu du nanofil 102, et grâce au champ électrique généré par le potentiel appliqué sur la grille arrière 120. De manière générale, cette valeur du SOiv peut être augmentée en réalisant le dispositif 100 tel que la grille avant 108 et la portion 102 forment un ensemble dissymétrique par rapport à un plan passant par le centre de la portion 102 et parallèle à au moins une des faces latérales 116 de la portion 102.

Dans un deuxième mode de réalisation, le SOiv est augmenté grâce à une dissymétrie de la grille avant 108 et/ou de la partie de la portion 102 recouverte par la grille avant 108 par rapport à un plan parallèle au plan (Y,Z) et passant par le milieu de la portion 102.

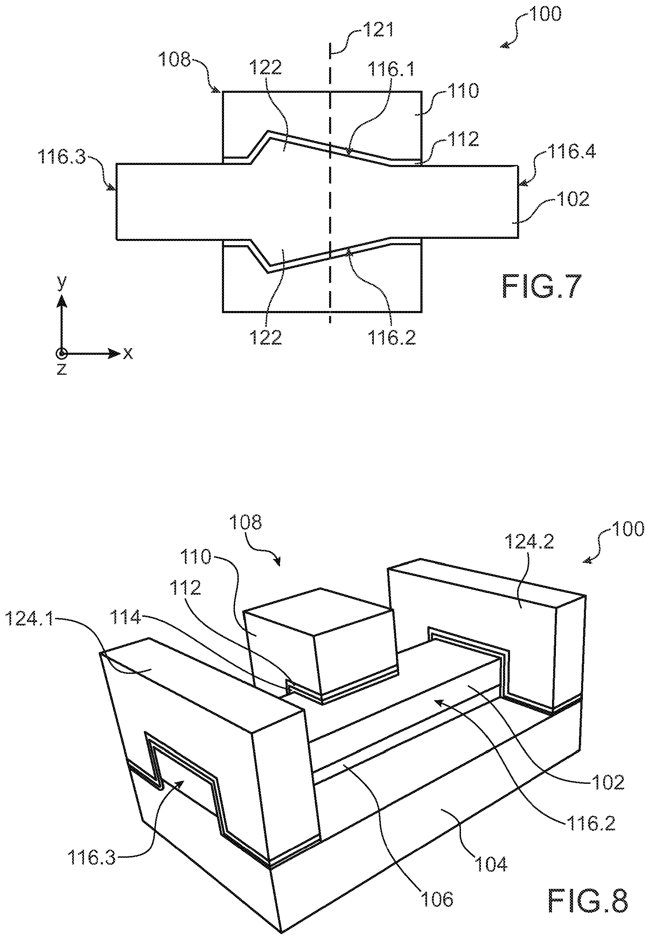

La figure 7 représente une vue en coupe du dispositif 100 selon ce deuxième mode de réalisation. Le trait pointillé désigné par la référence 121 représente symboliquement le plan par rapport auquel l'ensemble formé de la grille avant 108 et de la portion 102 présente une dissymétrie. Sur cette figure, la dissymétrie de la portion 102 provient du fait que de chaque côté de la portion 102, au niveau des faces latérales 116.1 et 116.2, la portion 102 comporte des parties saillantes 122 qui ne sont pas symétriques par rapport au plan 121.

En variante de l'exemple représenté sur la figure 7, il est possible que cette dissymétrie par rapport au plan 121 soit formée uniquement par la grille avant 108, par exemple en la réalisant en forme de biseau telle que la structure de cette grille avant 108 soit différente de part et d'autre du plan 121. Dans ce cas, la portion 102 peut être ou non dissymétrique par rapport au plan 121.

La figure 8 représente schématiquement le dispositif 100 selon un troisième mode de réalisation.

Le dispositif 100 comporte la portion 102, la couche diélectrique 104 et la grille avant 108 réalisés de manière analogue au premier mode de réalisation, c'est-à-dire tels que la grille avant 108 ne recouvre qu'une seule arrête supérieure 113 de la portion 102.

Le dispositif 100 comporte en outre des grilles latérales supplémentaires 124.1 et 124.2 disposées autour de chacune des deux extrémités de la portion 102, à proximité des faces latérales 116.3 et 116.4. Chacune des grilles latérales 124.1, 124.2 recouvre une partie de chacune des faces latérales 116.1 et 116.2 et de la face supérieure 115 de la portion 102. Ainsi, les grilles latérales 124.1 et 124.2 recouvrent des deuxièmes parties de la portion 102 situées de part et d'autre d'une première partie de la portion 102 définissant le qubit.

Dans l'exemple de la figure 8, les grilles latérales 124.1 et 124.2 sont similaires l'une par rapport à l'autre. En variante, il est possible que les grilles latérales 124.1 et 124.2 soient différentes l'une de l'autre.

Ces grilles latérales supplémentaires 124.1 et 124.2, disposées de chaque côté de la boîte quantique formée par la grille avant 108 et la partie de la portion 102 recouverte par la grille avant 108, permettent d'introduire une dissymétrie supplémentaire au sein du qubit, augmentant ainsi encore le SOiv, via l'application de potentiels électriques différents sur ces grilles latérales 124.1 et 124.2, et permettant ainsi de localiser la fonction d'onde de la charge électrique dont l'état du spin est manipulé dans une région de la portion 102 se trouvant sous la grille avant 108 mais non centrée par rapport à cette grille avant 108. Il est par exemple possible d'appliquer un premier potentiel électrique V1 sur la grille 124.1 et d'appliquer un deuxième potentiel électrique V2 sur la grille 124.1, avec V2 < V1 qui permet de localiser cette fonction d'onde à proximité de l'arrête supérieure 113 recouverte par la grille avant 108, du côté de la grille latérale 124.1. En choisissant V2 > V1, la fonction d'onde est alors localisée à proximité de l'arrête supérieure 113, mais du côté de la grille latérale 124.2.

La figure 9 représente l'augmentation de la valeur du SOiv obtenue en augmentant la valeur de la différence de potentiels V1 - V2 appliquée entre les grilles latérales 124.1, 124.2.

En variante des grilles latérales 124.1, 124.2, il est possible de former, autour de la grille avant 108, au moins deux espaceurs électriquement conducteurs, par exemple en polysilicium, formant des barrières remplissant une fonction similaire à celle des grilles latérales 124.1, 124.2. Ces espaceurs électriquement conducteurs sont disposés contre deux côtés opposés de la grille avant 108 et espacés du matériau conducteur 110 de la grille avant 108 par un matériau diélectrique interposé entre le matériau conducteur 110 et celui des espaceurs conducteurs.

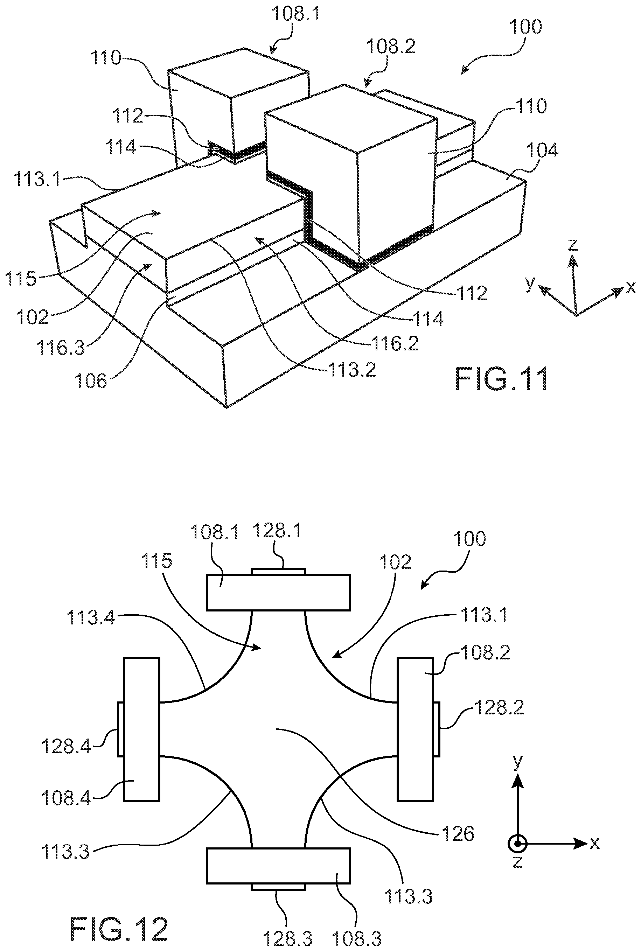

La figure 11 représente le dispositif 100 selon un quatrième mode de réalisation.

Dans ce quatrième mode de réalisation, la grille avant 108 comporte deux parties 108.1 et 108.2 distinctes recouvrant chacune une arrête supérieure de la portion 102. La première partie 108.1 de la grille avant 108 formée dans ce quatrième mode de réalisation est par exemple similaire à la grille avant 108 du dispositif 100 selon le premier mode de réalisation et recouvre partiellement l'arrête supérieure 113.1. La deuxième partie 108.2 de la grille avant recouvre l'arrête supérieure 113.2 formée à la jonction de la face supérieure 115 et de la face latérale 116.2, les deux arrêtes supérieures 113.1 et 113.2 recouvertes par les parties 108.1 et 108.2 étant sensiblement parallèles l'une de l'autre.

La figure 12 représente le dispositif 100 selon un cinquième mode de réalisation.

Dans ce cinquième mode de réalisation, la portion 102 comporte une partie centrale 126 et quatre extrémités 128.1 - 128.4 reliées à cette partie centrale 126. Sur l'exemple de la figure 12, la portion 102 a, dans le plan (X,Y) parallèle aux faces supérieures et inférieures 115, 117 de cette portion 102, une forme de croix.

Chacune des extrémités 128.1 - 128.4 est recouverte par une grille 108.1 -108.4 formant ensemble la grille avant 108 du dispositif 100. Chacune de ces grilles 108.1 - 108.4 recouvre une partie de la face supérieure 115 et des deux faces latérales se trouvant au niveau d'une des extrémités 128.1 - 128.4. Ainsi, chacune des grilles 108.1 - 108.4 recouvrent deux des arrêtes latérales supérieures de la portion 108 reliant les extrémités entre elles. Sur la figure 12, ces quatre arrêtes latérales supérieures portent les références 113.1- 113.4.

Lors d'une manipulation de l'état du spin du qubit formé dans la portion 102, la grille arrière 120 (non visible sur la figure 12) du dispositif 100 est polarisée négativement afin que la fonction d'onde de la charge électrique dont le spin est manipulé soit localisée à proximité de la face supérieure 115 de la portion 102. Les signaux électriques appliqués alors sur les grilles avant 108.1 - 108.4 permettent de localiser alors cette fonction d'onde à proximité d'une des arrêtes supérieures 113.1 - 113.4. Par exemple, pour localiser la fonction d'onde à proximité de l'arrête supérieure 113.1, la grille arrière 120 est polarisée négativement et les grilles 108.1 et 108.2 sont polarisées positivement afin forcer ce positionnement de la fonction d'onde. Sans ces potentiels électriques appliqués sur la grille arrière 120 et sur les grilles avant 108.1 - 108.4, la fonction d'onde est localisée dans la partie centrale 126 de la portion 102.

La figure 12 représente la portion 102 qui ne forme qu'un seul qubit. Lorsque le dispositif 100 comporte plusieurs qubits, la portion de semi-conducteur formant ces qubits peut correspondre à la juxtaposition de plusieurs portions 102 similaires à celle représentée sur la figure 12 et reliées entre elles par leurs extrémités 128.1 - 128.4. Chacune des grilles 108 formée sur une des extrémités peut être commune à deux qubits voisins.

## Revendications

1. Procédé de contrôle d'un dispositif quantique (100) à qubit de spin, dans lequel le dispositif quantique (100) comporte au moins :
- une portion de semi-conducteur (102) comprenant une face supérieure (115), une face inférieure (117) et des faces latérales (116) sensiblement perpendiculaires aux faces supérieure et inférieure (115, 117) ;
- une couche diélectrique (104) sur laquelle est disposée la portion de semi-conducteur (102) telle que la face inférieure (117) de la portion de semi-conducteur (102) soit disposée du côté de la couche diélectrique (104) ;
- une grille avant (108) recouvrant partiellement au moins une arrête supérieure (113) de la portion de semi-conducteur (102) formée à une jonction entre la face supérieure (115) et une première des faces latérales (116) ;
- une grille arrière (120) telle que la couche diélectrique (104) soit disposée entre la grille arrière (120) et la portion de semi-conducteur (102) ;
le procédé comprenant, lors d'une manipulation d'un état du spin du qubit du dispositif quantique (100) :
- l'exposition du dispositif quantique (100) à un champ magnétique B, **caractérisé par**
- l'application, sur la grille arrière (120), d'un potentiel électrique Vbg de valeur telle que Δ(Vbg) < g.µ_{B}.B + 2|M_{SO}|, et l'application, sur la grille avant (108), d'un potentiel électrique Vfg confinant au moins une charge électrique sous l'arrête supérieure (113) et d'un signal électrique RF déclenchant un changement d'état du spin du qubit du dispositif quantique (100),
avec g correspondant au facteur de Landé, µ_{B} correspondant au magnéton de Bohr, Δ correspondant à l'écart d'énergie inter-vallée dans la portion de semi-conducteur (102), et Mₛₒ le couplage spin-orbite inter-vallées du dispositif quantique (100).

2. Procédé selon la revendication 1, dans lequel le champ magnétique B auquel le dispositif quantique (100) est exposé est de valeur telle que g.µ_{B}.B > min(Δ(Vbg))-2|M_{SO}|.

3. Procédé selon l'une des revendications précédentes, comportant en outre, lors d'une phase d'initialisation ou de lecture du qubit, l'application du potentiel électrique Vbg de valeur telle que Δ(Vbg) > g.µ_{B}.B + 10|M_{SO}|.

4. Procédé selon l'une des revendications précédentes, dans lequel la portion de semi-conducteur (102) et/ou la grille avant (108) est dissymétrique par rapport à un plan passant par le centre de la portion de semi-conducteur (102) et parallèle à au moins une deuxième des faces latérales (116) de la portion de semi-conducteur (102).

5. Procédé selon la revendication 4, dans lequel les première et deuxième faces latérales (116) de la portion de semi-conducteur (102) correspondent à la même face latérale (116.1) de la portion de semi-conducteur (102).

6. Procédé selon l'une des revendications précédentes, dans lequel la grille avant (108) recouvre une seule arrête supérieure (113) de la portion de semi-conducteur (102).

7. Procédé selon l'une des revendications 1 à 3, dans lequel la grille avant (108) comporte deux parties (108.1, 108.2) distinctes recouvrant chacune une seule arrête supérieure (113.1, 113.2) de la portion de semi-conducteur (102) formée à une jonction de la face supérieure (115) et de l'une des faces latérales (116) de la portion de semi-conducteur (102), les deux arrêtes supérieures (113.1,113.2) recouvertes par les deux parties (108.1, 108.2) distinctes de la grille avant (108) étant sensiblement parallèles l'une de l'autre.

8. Procédé selon l'une des revendications précédentes, dans lequel le dispositif quantique (100) comporte en outre au moins deux grilles latérales (124.1, 124.2) recouvrant des deuxièmes parties de la portion de semi-conducteur (102) situées de part et d'autre d'une première partie de la portion de semi-conducteur définissant le qubit, et dans lequel, lors de la manipulation de l'état du spin du qubit du dispositif quantique (100), des potentiels électriques de valeurs différentes l'une de l'autre sont appliqués sur les deux grilles latérales (124.1, 124.2).

9. Procédé selon l'une des revendications précédentes, dans lequel le dispositif quantique (100) comporte en outre au moins deux espaceurs électriquement conducteurs distincts et disposés contre deux côtés opposés de la grille avant (108), et dans lequel, lors de la manipulation de l'état du spin du qubit du dispositif quantique (100), des potentiels électriques de valeurs différentes l'une de l'autre sont appliqués sur les deux espaceurs électriquement conducteurs.

10. Procédé selon l'une des revendications 1 à 3, dans lequel la portion de semi-conducteur (102) comporte quatre extrémités (128.1 - 128.4) reliées à une partie centrale (126) et chacune recouverte au moins partiellement par une partie (108.1 - 108.4) de la grille avant (108) distincte des autres parties de la grille avant (108), et dans lequel, lors de la manipulation de l'état du spin du qubit du dispositif quantique (100), le signal RF est appliqué sur deux parties voisines de la grille avant (108).

11. Procédé selon l'une des revendications précédentes, dans lequel le dispositif quantique (100) comporte plusieurs qubits de spin formés dans plusieurs portions de semi-conducteur (102) distinctes, la grille arrière (120) étant couplée à l'ensemble des portions de semi-conducteur (102).

12. Procédé selon l'une des revendications 1 à 10, dans lequel le dispositif quantique (100) comporte plusieurs qubits de spin formés dans plusieurs portions de semi-conducteur (102) distinctes, et comporte plusieurs grilles arrières (120) chacune couplée à l'une des portions de semi-conducteur (102).

## Patentansprüche

1. Verfahren zum Steuern einer Spin-Qubit-Quantenvorrichtung (100), wobei die Quantenvorrichtung (100) zumindest enthält:
- einen Halbleiterabschnitt (102) mit einer oberen Fläche (115), einer unteren Fläche (117) und Seitenflächen (116), die im Wesentlichen senkrecht zu der oberen und unteren Fläche (115, 117) verlaufen;
- eine dielektrische Schicht (104), auf der der Halbleiterabschnitt (102) so angeordnet ist, dass die untere Fläche (117) des Halbleiterabschnitts (102) auf der Seite der dielektrischen Schicht (104) angeordnet ist;
- ein vorderes Gate (108), das zumindest eine obere Kante (113) des Halbleiterabschnitts (102) teilweise bedeckt, die an einem Übergang zwischen der oberen Fläche (115) und einer ersten der Seitenflächen (116) ausgebildet ist;
- ein hinteres Gate (120), derart, dass die dielektrische Schicht (104) zwischen dem hinteren Gate (120) und dem Halbleiterabschnitt (102) angeordnet ist; wobei das Verfahren beim Manipulieren eines Qubit-Spinzustands der Quantenvorrichtung (100) umfasst:
- Aussetzen der Quantenvorrichtung (100) einem Magnetfeld B, **gekennzeichnet durch**
- Anlegen eines elektrischen Potentials Vbg an das hintere Gate (120) mit einem solchen Wert, dass Δ(Vbg) < g.µ_{B}.B + 2|Mₛₒ|, und Anlegen eines elektrischen Potentials Vfg, das zumindest eine elektrische Ladung unter der oberen Kante (113) einschließt, und eines elektrischen HF-Signals, das eine Zustandsänderung des Qubit-Spins der Quantenvorrichtung (100) auslöst, an das vordere Gate (108),
wobei g dem Lande-Faktor entspricht, µ_{B} dem bohrschen Magneton entspricht, Δ der Energielücke zwischen den Tälern im Halbleiterabschnitt (102) entspricht, und Mₛₒ der Spin-Bahn-Kopplung zwischen den Tälern der Quantenvorrichtung (100) entspricht.

2. Verfahren nach Anspruch 1, wobei das Magnetfeld B, dem die Quantenvorrichtung (100) ausgesetzt wird, einen solchen Wert hat, dass g.µ_{B}.B > min(Δ(Vbg))-2|Mₛₒ|.

3. Verfahren nach einem der vorhergehenden Ansprüche, ferner umfassend, während einer Initialisierungs- oder Lesephase des Qubits, das Anlegen des elektrischen Potentials Vbg mit einem solchen Wert, dass Δ(Vbg) > g.µ_{B}.B + 10|Mₛₒ|.

4. Verfahren nach einem der vorhergehenden Ansprüche, wobei der Halbleiterabschnitt (102) und/oder das vordere Gate (108) asymmetrisch in Bezug auf eine Ebene ist, die durch die Mitte des Halbleiterabschnitts (102) und parallel zu zumindest einer zweiten der Seitenflächen (116) des Halbleiterabschnitts (102) verläuft.

5. Verfahren nach Anspruch 4, wobei die erste und die zweite Seitenfläche (116) des Halbleiterabschnitts (102) der gleichen Seitenfläche (116.1) des Halbleiterabschnitts (102) entsprechen.

6. Verfahren nach einem der vorhergehenden Ansprüche, wobei das vordere Gate (108) eine einzige obere Kante (113) des Halbleiterabschnitts (102) bedeckt.

7. Verfahren nach einem der Ansprüche 1 bis 3, wobei das vordere Gate (108) zwei separate Teile (108.1, 108.2) enthält, die jeweils eine einzige obere Kante (113.1, 113. 2) des Halbleiterabschnitts (102) bedecken, die an einem Übergang der oberen Fläche (115) und einer der Seitenflächen (116) des Halbleiterabschnitts (102) ausgebildet ist, wobei die beiden oberen Kanten (113.1, 113.2), die von den beiden separaten Teilen (108.1, 108.2) des vorderen Gates (108) bedeckt werden, im Wesentlichen parallel zueinander verlaufen.

8. Verfahren nach einem der vorhergehenden Ansprüche, wobei die Quantenvorrichtung (100) ferner zumindest zwei seitliche Gates (124.1, 124.2) enthält, welche zweite Teile des Halbleiterabschnitts (102) bedecken, die sich auf beiden Seiten eines ersten Teils des Halbleiterabschnitts befinden, der das Qubit definiert, und wobei beim Manipulieren des Spinzustands des Qubits der Quantenvorrichtung (100) elektrische Potentiale mit voneinander verschiedenen Werten an die beiden seitlichen Gates (124.1, 124.2) angelegt werden.

9. Verfahren nach einem der vorhergehenden Ansprüche, wobei die Quantenvorrichtung (100) ferner zumindest zwei unterschiedliche elektrisch leitende Spacer enthält, die an zwei gegenüberliegenden Seiten des vorderen Gates (108) angeordnet sind, und wobei beim Manipulieren des Spinzustandes des Qubits der Quantenvorrichtung (100) elektrische Potentiale mit voneinander verschiedenen Werten an die beiden elektrisch leitenden Spacer angelegt werden.

10. Verfahren nach einem der Ansprüche 1 bis 3, wobei der Halbleiterabschnitt (102) vier Enden (128.1 - 128.4) aufweist, die mit einem zentralen Teil (126) verbunden sind und jeweils zumindest teilweise von einem Teil (108.1 - 108.4) des vorderen Gates (108) bedeckt werden, der sich von den anderen Teilen des vorderen Gates (108) unterscheidet, und wobei beim Manipulieren des Spinzustands des Qubits der Quantenvorrichtung (100) das HF-Signal an zwei benachbarte Teile des vorderen Gates (108) angelegt wird.

11. Verfahren nach einem der vorhergehenden Ansprüche, wobei die Quantenvorrichtung (100) mehrere Spin-Qubits umfasst, die in mehreren verschiedenen Halbleiterabschnitten (102) ausgebildet sind, wobei das hintere Gate (120) mit allen Halbleiterabschnitten (102) gekoppelt ist.

12. Verfahren nach einem der Ansprüche 1 bis 10, wobei die Quantenvorrichtung (100) mehrere Spin-Qubits enthält, die in mehreren verschiedenen Halbleiterabschnitten (102) ausgebildet sind, und mehrere hintere Gates (120) enthält, die jeweils mit einem der Halbleiterabschnitte (102) gekoppelt sind.

## Claims

1. A method for controlling a spin qubit quantum device (100), wherein the quantum device (100) includes at least:
- a semiconductor portion (102) comprising an upper face (115), a lower face (117) and side faces (116) substantially perpendicular to the upper and lower faces (115, 117);
- a dielectric layer (104) on which the semiconductor portion (102) is disposed such that the lower face (117) of the semiconductor portion (102) is disposed on the side of the dielectric layer (104);
- a front gate (108) partially covering at least one upper ridge (113) of the semiconductor portion (102) formed at a junction between the upper face (115) and a first of the side faces (116);
- a rear gate (120) such that the dielectric layer (104) is disposed between the rear gate (120) and the semiconductor portion (102);
the method comprising, upon manipulating a spin state of the qubit of the quantum device (100):
- exposing the quantum device (100) to a magnetic field B,
**characterized by**
- applying, to the rear gate (120), an electric potential Vbg having a value such that Δ(Vbg) < g.µ_{B}.B + 2|M_{SO}|, and applying, to the front gate (108), an electric potential Vfg confining at least one electric charge under the upper ridge (113) and an electric RF signal triggering a change in spin state of the qubit of the quantum device (100),
with g corresponding to the Lande factor, µ_{B} corresponding to the Bohr magneton, Δ corresponding to the valley-orbit splitting in the semiconductor portion (102), and Mₛₒ the inter-valley spin-orbit coupling of the quantum device (100).

2. The method according to claim 1, wherein the magnetic field B to which the quantum device (100) is exposed has a value such that g.µ_{B}.B > min(Δ(Vbg))-2|M_{SO}|.

3. The method according to one of the preceding claims, further including, during a phase of initialising or reading the qubit, applying the electric potential Vbg having a value such that Δ(Vbg) > g.µ_{B}.B + 10|M_{SO}|.

4. The method according to one of the preceding claims, wherein the semiconductor portion (102) and/or the front gate (108) are dissymmetric relative to a plane passing through the centre of the semiconductor portion (102) and parallel to at least one second of the side faces (116) of the semiconductor portion (102).

5. The method according to claim 4, wherein the first and second side faces (116) of the semiconductor portion (102) correspond to the same side face (116.1) of the semiconductor portion (102).

6. The method according to one of the preceding claims, wherein the front gate (108) covers a single upper ridge (113) of the semiconductor portion (102).

7. The method according to one of claims 1 to 3, wherein the front gate (108) includes two distinct parts (108.1, 108.2) each covering a single upper ridge (113.1, 113.2) of the semiconductor portion (102) formed at a junction of the upper face (115) and one of the side faces (116) of the semiconductor portion (102), both upper ridges (113.1, 113.2) covered with both distinct parts (108.1, 108.2) of the front gate (108) being substantially parallel to each other.

8. The method according to one of the preceding claims, wherein the quantum device (100) further includes at least two side gates (124.1, 124.2) covering second parts of the semiconductor portion (102) which are located on either side of a first part of the semiconductor portion defining the qubit, and wherein, upon manipulating the spin state of the qubit of the quantum device (100), electric potentials having different values from each other are applied to both side gates (124.1, 124.2).

9. The method according to one of the preceding claims, wherein the quantum device (100) further includes at least two distinct electrically conducting spacers which are disposed against two opposite sides of the front gate (108), and wherein, upon manipulating the spin state of the qubit of the quantum device (100), electric potentials having different values from each other are applied to both electrically conducting spacers.

10. The method according to one of claims 1 to 3, wherein the semiconductor portion (102) includes four ends (128.1 - 128.4) connected to a centre part (126) and each covered at least partially with a part (108.1 - 108.4) of the front gate (108) which is distinct from the other parts of the front gate (108), and wherein, upon manipulating the spin state of the qubit of the quantum device (100), the RF signal is applied to two neighbouring parts of the front gate (108).

11. The method according to one of the preceding claims, wherein the quantum device (100) includes several spin qubits formed in several distinct semiconductor portions (102), the rear gate (120) being coupled with all the semiconductor portions (102).

12. The method according to one of claims 1 to 10, wherein the quantum device (100) includes several spin qubits formed in several distinct semiconductor portions (102), and includes several rear gates (120) each coupled with one of the semiconductor portions (102).
